Europäisches Patentamt

**European Patent Office**

**Office européen des brevets**

(11) Publication number: **0 327 160 B1**

(12) **EUROPEAN PATENT SPECIFICATION**

(45) Date of publication of patent specification: **03.11.93**  (51) Int. Cl.⁵: **H03K 17/16, H03K 19/003**

(21) Application number: **89200159.5**

(22) Date of filing: **25.01.89**

(54) **Integrated circuit comprising logic circuits and at least one push-pull stage.**

(30) Priority: **01.02.88 NL 8800234**

(43) Date of publication of application:
**09.08.89 Bulletin 89/32**

(45) Publication of the grant of the patent:
**03.11.93 Bulletin 93/44**

(84) Designated Contracting States:
**DE FR GB IT SE**

(56) References cited:
| | |
|---|---|
| EP-A- 0 140 188 | EP-A- 0 250 036 |
| DE-A- 3 114 132 | GB-A- 2 177 865 |
| US-A- 4 199 695 | US-A- 4 645 947 |

**PATENT ABSTRACTS OF JAPAN, vol. 8, no. 39 (E-228)[1476], 21st February 1984, page 18 E 228 & JP-A-58-196 726**

(73) Proprietor: **N.V. Philips' Gloeilampenfabrieken Groenewoudseweg 1 NL-5621 BA Eindhoven(NL)**

(72) Inventor: **Dikken, Jan c/o INT. OCTROOIBUREAU B.V. Prof. Holstlaan 6 NL-5656 AA Eindhoven(NL)**

(74) Representative: **Strijland, Wilfred et al INTERNATIONAAL OCTROOIBUREAU B.V. Prof. Holstlaan 6 NL-5656 AA Eindhoven (NL)**

EP 0 327 160 B1

Rank Xerox (UK) Business Services
(3. 10/3.6/3.3. 1)

## Description

The invention relates to an integrated logic circuit with a push-pull stage which comprises, connected in a first path between a first power supply line which carries a high supply voltage and a stage output, a current channel of a push transistor and, connected in a second path between the stage output and a second power supply line which carries a low supply voltage, a current channel of a pull transistor, there being provided control means which are connected to control electrodes of the push transistor and the pull transistor in order to generate, when a logic state of the stage changes, time-dependent control voltages in order to reduce voltage noise on the power supply lines which is caused by current variations on the stage output.

Such an IC comprising a push-pull stage is known from Netherlands Patent Application 8601558. The known push-pull stage comprises control means for generating time-dependent control voltages on the control electrodes of the push transistor and the pull transistor in order to reduce voltage noise on the internal power supply lines of the circuit. Due to variations of the load current with which the push-pull stage supplies an output load, induction voltages are generated across inductances present in the power supply lines. The control means control the currents through the push transistor and the pull transistor so that the currents are varied by a constant amount per unit of time during switching. Consequently, the said load current, being the difference between these currents, is also varied by a constant amount per unit of time. When the load current is made to vary linearly in time, the maximum value of the interfering voltages induced thereby is limited.

From DE-A-31 14 132 an electronic switch is known, wherein respective signal sources are connected alternately to an output through respective transistors. The switching of the transistors is such that both transistors are simultaneously conductive for a short time period.

It is an object of the invention to improve the known push-pull stage by reducing the induction voltages occurring on the power supply lines even further. To achieve this, an integrated circuit in accordance with the invention is characterized in that during the switching of the push-pull stage the control means keep a first current through one transistor of the stage substantially constant until a greatest rise has occurred of a second current through the other transistor of the stage, for substantially instantly thereupon reducing the first current. This results in mutually time shifting of current peak and, accordingly, of maximum current-changes. As a result, the accummulation of inductive voltages is prevented.

An embodiment of an integrated circuit in accordance with the invention in which the control means comprise controllable charging paths and discharging paths which are connected to the control electrodes of the push transistor and the pull transistor is characterized in that in its conductive state the discharging path between the control electrode of the pull transistor and the second power supply line conducts a substantially smaller maximum current than the charging path between the first power supply line and the control electrode of the push transistor in the conductive state of said charging path. The push transistor is then fully conductive before a current through the pull transistor can vary substantially; this is due on the one and to the rise of the driving voltage across the pull transistor and on the other hand to the decrease of the control voltage of the pull transistor.

A further embodiment of an integrated circuit in accordance with the invention is characterized in that the discharging path for the control electrode of the push transistor comprises a current channel of a discharging transistor, which current channel connects a node between the current channels of the push transistor and the pull transistor to the control electrode of the push transistor. Just before the blocking of the push transistor, a current through this transistor is substantially independent of a voltage across its current channel which is referred to herein as the driving voltage. By thus connecting the control electrode of the push transistor, when this transistor is going to be blocked, to a node between the current channels of the push transistor and the pull transistor via the discharging transistor, during which operation the pull transistor is made conductive, the push transistor initially continues to supply a substantially constant current. This situation changes only when the voltage at said node has dropped so far below the voltage of the control electrode of the discharge transistor that the latter transistor starts to discharge the input of the push transistor.

Another embodiment of a push-pull stage in accordance with the invention is characterized in that the control means comprise a control circuit which includes a switching transistor, a current channel of which is connected to the control electrode of the push transistor in series with the relevant charging path, which switching transistor forms an inverter circuit in conjunction with the discharging transistor, the control means comprising a second control circuit which includes a second inverter circuit which has an output connected to the control electrode of the pull transistor and which is formed by a second switching transistor, having a current channel connected between the control electrode of the pull transistor and the relevant charging path, and by a second discharging transistor having a current channel connected between the control electrode of the pull transistor and the second power supply line, the charging paths of the first and the second control circuit each comprising, connected to the second power supply line, a current channel of a respective cascode transistor, a control electrode of which is connected to the output of the respective inverter circuit, and also comprising, connected parallel to the current channel of the respective cascode transistor, a current channel of a respective further cascode transistor, an input of the first and the second inverter circuit being connected, via a first and a second delay element, respectively, to a control electrode of the respective further cascode transistors.

The further cascode transistor is made conductive after a delay. Initially this cascode transistor does not influence the voltages in the inverter circuit which generates, as described in the state of the art, a suitable control voltage which ensures a linear variation in time of the currents switched by the transistors of the push-pull stage. The further cascode transistor raises the output voltage of the inverter circuit to the voltage level of the first power supply line only after expiration of a given period of time. In comparison with the state of the art, this is a better way of keeping the current variation in time to be substantially linear. According to the state of the art the further cascode transistor is rendered conductive without delay, so that the said variation of the current in time in the push transistor or the pull transistor is influenced from the very beginning.

Another embodiment yet of a push-pull stage in accordance with the invention is characterized in that the discharging path between the control electrode of the pull transistor and the second power supply line comprises at least two parallel paths, a first path of which can be switched off in dependence on a control signal to be applied to the control means while a second path can be switched off in dependence on a voltage on a gate output of a logic gate, gate inputs of which are connected to the control electrode of the pull transistor and to the stage output. For example, in the case of an extremely large capacitive load on the stage output the pull transistor could be blocked prematurely, thus causing large current variations and hence high induction voltages. By switching off a part of the discharging path in these circumstances, a more gradual current variation through the pull transistor is achieved.

The invention will be described in detail hereinafter with reference to a drawing; therein:

Fig. 1 shows a circuit diagram of a push-pull stage,

Figs. 2A and 2B illustrate a current variation in a push-pull stage according to the state of the art,

Figs. 3A and 3B show a current variation in a push-pull stage in an integrated circuit in accordance with the invention,

Fig. 4 shows a preferred embodiment of a push-pull stage in an integrated circuit in accordance with the invention, and

Fig. 5 shows a detail of the push-pull stage in the integrated circuit shown in Fig. 4.

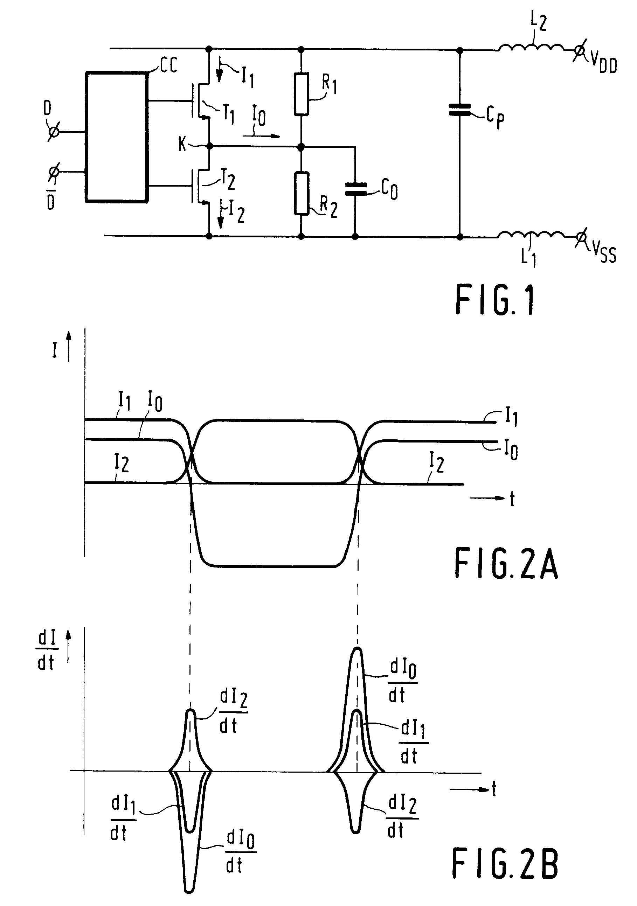

Fig. 1 shows a circuit diagram of a push-pull stage. The stage comprises a cascode connection of a push transistor $T_1$ and a pull transistor $T_2$ between power supply lines carrying the supply voltages $V_{DD}$ and $V_{SS}$. The output K of the stage is loaded by, for example, a TTL circuit which is represented in the Figure by resistances $R_1$ and $R_2$, connected in series between the power supply lines, and a capacitance $C_0$ which is connected parallel to the resistance $R_2$. The stage also comprises a control circuit CC, inputs of which receive logic signals D and $\overline{D}$. The transistors $T_1$ and $T_2$ are controlled by means of mutually logically complementary control signals. The load current $I_0$ at all times equals the difference between the current $I_1$ conducted by the transistor $T_1$ and the current $I_2$ conducted by the transistor $T_2$. For example, when the push transistor $T_1$ is made conductive and the pull transistor $T_2$ is blocked substantially simultaneously, the variation of the current $I_1$ per unit of time amounts to: $dI_1/dt$, positive, and the variation of the current $I_2$ per unit of time is: $dI_2/dt$, negative. The variation of the load current $I_0$ per unit of time ($dI_0/dt$) equals the sum of the absolute values of the variations in $I_1$ and $I_2$:

$$dI_0/dt = |dI_1/dt| + |dI_2/dt|.$$

On the internal power supply lines, inevitably forming parasitic inductances $L_1$ and $L_2$ and being coupled via a parasitic capacitance $C_p$, this current variation $\overline{dI_0}/dt$ causes a high induction voltage, giving rise to interference (for example, in the logic state of other parts of an integrated circuit in which the push-pull stage is included).

Figs. 2A and 2B illustrate the variation in time of the currents $I_1$ and $I_2$ and the load current $I_0$, and their time derivatives, for a circuit according to the present state of the art. When the most significant variations in the currents $I_1$ and $I_2$ coincide substantially in time, the variation $dI_0/dt$ generates a maximum induction voltage equal to the sum of the absolute extreme values of $dI_1/dt$ and $dI_2/dt$.

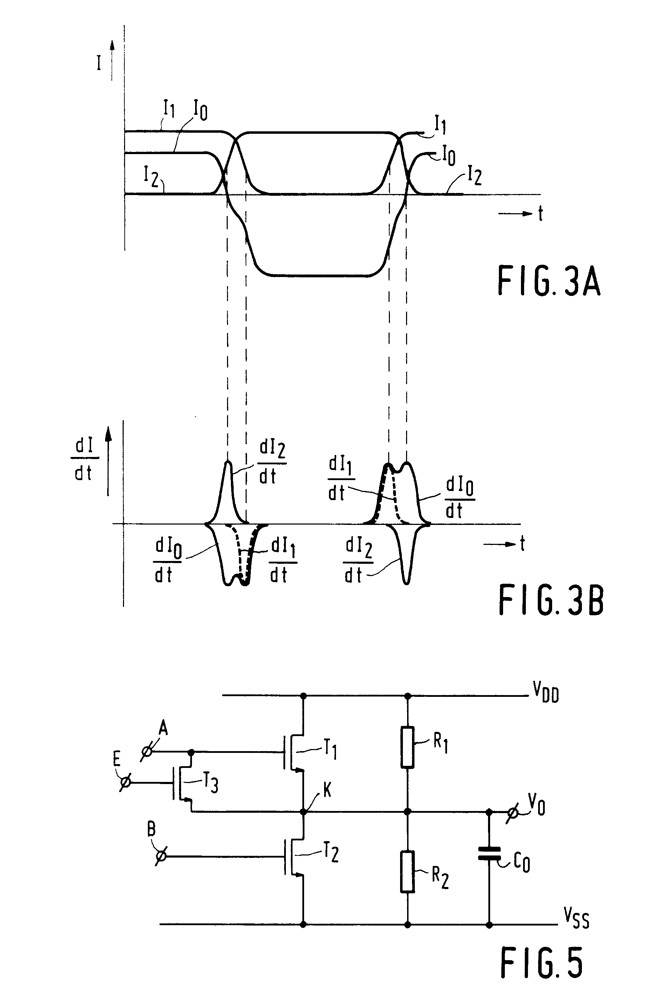

Figs. 3A and 3B illustrate the variation in time of the currents $I_1$ and $I_2$ and the load current $I_0$, and their time derivatives, for a circuit in accordance with the invention. Because the extreme values of $dI_1/dt$ and $dI_2/dt$ have been shifted in time with respect to one another, the maximum induction voltage $dI_0/dt$ is substantially a factor 2 smaller than in the case illustrated with reference to the Figs. 2A and 2B.

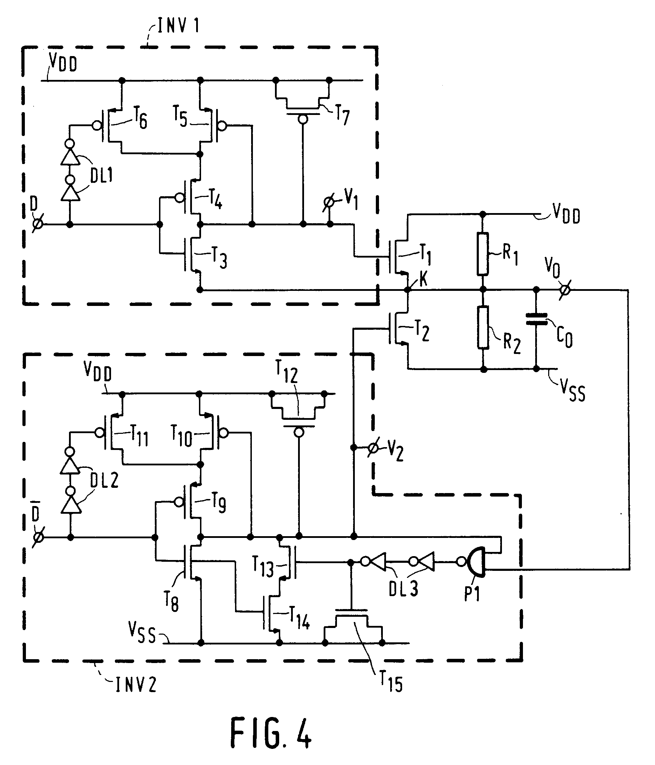

Fig. 4 shows a preferred embodiment of a push-pull stage in accordance with the invention. A TTL load, represented by resistances $R_1$, $R_2$ and a capacitance $C_0$, is connected to output terminal K of the stage which comprises a push transistor $T_1$ and a pull transistor $T_2$. The push transistor $T_1$ receives a control signal $V_1$ from a first control circuit INV1 and the pull transistor $T_2$ receives a control signal $V_2$ from a second control circuit INV2. Both control circuits INV1 and INV2 comprise a controllable discharging path which is formed by a transistor $T_3$ and a transistor $T_8$, respectively. The function of the transistor $T_3$, being connected between the control electrode of the pull transistor $T_1$ and the output terminal K, will be described with reference to Fig. 5. The charging paths of the control circuits INV1 and INV2 comprise transistors $T_4$ to $T_7$ and $T_9$ to $T_{12}$, respectively. Because the charging paths have the same construction, only that of the control circuit INV1 will be described hereinafter. A similar reasoning applies to the charging path in the control circuit INV2. Therefore, when reference is made to a component of the control circuit INV1, a reference to a corresponding component of the control circuit INV2 is stated between parentheses. The transistor $T_4$ ($T_9$) serves as a switch for the transistor $T_5$ ($T_{10}$) which is connected as a current source and which has a control electrode connected to the control electrode of the push transistor $T_1$ (pull transistor $T_2$). Using this set-up, such a time-dependent control signal $V_1$ ($V_2$) is formed that, when the push transistor $T_1$ (pull transistor $T_2$) is activated, the current therethrough increases approximately linearly in time. This linear time dependency limits the maximum value of the interference voltages induced by the current variations in the push-pull stage. Because $T_5$ ($T_{10}$) is cut off further as the control voltage $V_1$ ($V_2$) increases, there is provided a parallel transistor $T_6$ ($T_{11}$) which raises the control voltage $V_1$ ($V_2$) to the supply voltage $V_{DD}$ after a retardation via the delay DL1 (DL2). Due to the delayed switching-on of the parallel transistor, it initially has no effect on the control voltage variation realized by the transistor $T_5$ ($T_{10}$). In ordere to improve the control voltage variation of $V_1$ ($V_2$) for a current which varies linearly in time in the push transistor $T_1$ (pull transistor $T_2$) when the control voltage $V_1$ ($V_2$) approaches the supply voltage $V_{DD}$, there is provided a non-linear capacitance which is realized by means of the transistor $T_7$ ($T_{12}$). Because this capacitance decreases strongly as the control voltage $V_1$ ($V_2$) increases beyond a voltage equal to $V_{DD}$ minus a threshold, an excessively low charging current via the transistors $T_5$ and $T_6$ ($T_{10}$ and $T_{11}$) to the control electrode of the push transistor $T_1$ (pull transistor $T_2$) is compensated for in said control voltage interval. In order to enable the current through the pull transistor $T_2$ to be kept substantially constant when the push transistor $T_1$ is turned on, the discharging path for the control electrode of the pull transistor $T_2$, comprising the transistors $T_8$, $T_{13}$ and $T_{14}$, is proportioned with respect to the charging path for the control electrode of the push transistor $T_1$, comprising the transistors $T_4$, $T_5$ and $T_6$, in such a way, that the maximum discharge current through the former discharging path is a factor from 1.5 to 10 smaller than the maximum charging current through the latter charging path. For a W/L ratio of 535/1.3 for the push transistor $T_1$ and of 531/1.3 for the pull transistor $T_2$, it has been found that the following W/L ratios suffice:

- $T_4$ : 80/1.3 - $T_5$ : 30/1.3 - $T_6$ : 40/1.3
- $T_8$ : 2/1.3 - $T_{10}$ : 14/1.3 - $T_{14}$ : 14/1.3.

It is thus achieved that the push transistor $T_1$ is already fully conductive before a current through the pull transistor $T_2$ changes substantially. The pull transistor $T_2$ then operates in the linear range. The decrease of the control voltage on the control electrode of $T_2$ and the increase of the driving voltage across the current channel of $T_2$ oppose one another in as far as the current variation is concerned. The discharging path in INV2 comprises a first path with transistors $T_8$ and a second path with transistors $T_{13}$ and $T_{14}$. The transistors $T_8$ and $T_{14}$ receive the same control signal, the transistor $T_{13}$ receiving a signal from a logic NAND gate $P_1$. The gate $P_1$ fed on the one hand by the control signal for the pull transistor $T_2$ ($V_2$) and on the other hand by the output voltage $V_0$ on the terminal K. For example, if the load capacitance $C_0$ or the load resistance $R_1$ were very high, the switching off of the pull transistor $T_2$ would be too fast when the discharging path is fully conductive, thus causing an excessively large current variation and hence an excessively high induction voltage. This can be avoided by temporary switching off a part of the discharging path. When the control signal $V_2$ is high and the output voltage $V_0$ still has a level above a predetermined value, the transistor $T_{13}$ is blocked via the NAND-gate $P_1$. The instant of switching on or off of the transistor $T_{13}$ depends inter alia on a transition point of the gate $P_1$, the dimensions of the transistors forming the gate, and on a delay DL3, if any, between the gate output of the gate $P_1$ and the control electrode of the transistor $T_{13}$. The capacitance $T_{15}$ serves to achieve gradual switching of the transistor $T_{13}$.

Fig. 5 shows a detail of the push-pull stage shown in Fig. 4. The push transistor $T_1$ and the pull

transistor $T_2$ are shown, and also the TTL load which is represented by the resistances $R_1$, $R_2$ and the capacitance $C_0$, which load is connected to the output terminal K. Terminals A and B are connected to further parts of the control circuit (not shown). Between the control electrode of the push transistor $T_1$ and the output terminal K there is formed a discharging path which includes a discharging transistor $T_3$. Just before the instant of switching off, the push transistor $T_1$ operates in the saturated state. The current conducted is thus independent of a driving voltage across the current channel. The output voltage $V_0$ on the output terminal K is then high. The switching off of the push transistor $T_1$ is preceded by the switching on of the pull transistor $T_2$, the uncoupling of the terminal A from the remainder of the control circuit, and the activation of the further transistor $T_3$ by means of a high voltage. Via the terminal E the further transistor $T_3$ is driven to full output when the push transistor $T_1$ is switched off; because the output voltage $V_0$ is still high at that instant, the further transistor $T_3$ will operate beyond or near its treshold voltage, which implies that the control electrode of the push transistor $T_1$ is not discharged or only hardly so. During the decreasing of the output voltage $V_0$, the push transistor $T_1$ remains saturated and delivers a constant current. It is only when the output voltage $V_0$ has decreased sufficiently far that the further transistor $T_3$ starts to conduct so that the control electrode of the push transistor $T_1$ is discharged further.

**Claims**

1. An integrated logic circuit with a push-pull stage comprising:

   a push transistor (T1) having a current channel arranged between a first power supply line for carrying a high supply voltage (VDD) and a stage output (K);

   a pull transistor (T2) having a current channel arranged between the output (K) and a second power supply line for carrying a low supply voltage (VSS);

   control means (CC) for supplying to a control electrode of the push transistor (T1) and to a control electrode of the pull transistor (T2) time-dependent control voltages in order to switch logic states of the push pull stage and in order to reduce voltage noise on the supply lines due to current variations at the stage output (K);

   characterized in that, during the switching of the logic states, the control means (CC) keep a first current (I1 or I2, respectively) through one of said transistors (T1 or T2, respectively) substantially constant until a greatest rise has occurred in a second current (I2 or I1, respectively) through the other one of said transistors (T2 or T1, respectively), for substantially instantly thereupon reducing the first current (I1 or I2, respectively).

2. An integrated logic circuit as in claim 1, wherein the control means (CC) comprises a discharging path (T8, T13, T14) being arranged between the control electrode of the pull transistor (T2) and the second power supply line, and a charging path (T4, T5, T6) being arranged between the control electrode of the push transistor (T1) and the first power supply line, characterized in that, the discharging path (T8, T13, T14) conducts a smaller maximum current when conductive than does the charging path (T4, T5, T6) when conductive.

3. An integrated logic circuit as in claim 2, characterized in that a ratio between the maximum current conducted by the charging path (T4, T5, T6) and the maximum current conducted by the discharging path (T8, T13, T14) lies in a range of 1,5 to 10.

4. An integrated logic circuit as in claim 2 or 3, characterized in that the control means (CC) comprises a further discharging path for discharging the control electrode of the push transistor (T1), said further discharging path comprising a current channel of a discharging transistor (T3) that connects the control electrode of the push transistor (T1) to a node (K) between the current channel of the push transistor (T1) and the current channel of the pull transistor (T2).

5. An integrated logic circuit as in claim 4, characterized in that the control means (CC) comprises a control circuit (INV1) wherein, in the charging path (T4, T5, T6), a current channel of a switching transistor (T4) is connected to the control electrode of the push transistor (T1), the switching transistor (T4) forming an inverter circuit in conjunction with the discharging transistor (T3).

6. An integrated logic circuit as in claim 5, wherein the control means (CC) comprises a second control circuit (INV2) which includes a second inverter circuit (T8, T9) that has an output connected to the control electrode of the pull transistor (T2) and that is formed by a second switching transistor (T9), with a current channel connected to the control electrode of the pull transistor (T2) and arranged in a charging path (T9, T10, T11) for the control electrode of the pull transistor (T2), and by a second discharging transistor (T8), with a current channel connected between the control electrode of the pull transistor (T2) and the second power supply line;

and wherein the charging paths (T4, T5, T6; T9, T10, T11) in each of the first and second control circuits (INV1 and INV2) comprises a respective cascode transistor (T5; T10), having a current channel connected to the first power supply line and having a control electrode connected to an output of the respective inverter circuit (T3, T4; T8, T9), and comprises a respective further cascode transistor (T6; T11), having a current channel connected in parallel to the current channel of the respective cascode transistor (T5; T10); characterized, in that inputs of the first and second inverter circuits (T3, T4; T8, T9) are connected, respectively, to a control electrode of the respective further cascode transistor (T6; T11) via a first and a second delay element (DL1; DL2), respectively.

7. An integrated logic circuit as in claim 2, 3, 4, 5 or 6, characterized in that the discharging path (T8, T13, T14) between the control electrode of the pull transistor (T2) and the second power supply line comprises a parallel arrangement of at least a first and a second path, the first path (T8) being turned off depending on a control signal supplied to the control means (CC) and the second path (T13, T14) being turned off under control of a voltage at a gate output of a logic gate (P1), the logic gate (P1) having a first gate input connected to the control electrode of the pull transistor (T2) and a second gate input connected to the stage output (K).

8. An integrated logic circuit as in claim 7, characterized in that a further delay element (DL3) is connected between the gate output and a control electrode of a specific transistor (T13) that has a current channel arranged in the second path (T13, T14).

9. An integrated logic circuit as in claim 8, characterized in that the control electrode of the specific transistor (T13) is coupled to the second power supply line via a further capacitance (T15).

**Patentansprüche**

1. Integrierte Logikschaltung mit einer Gegentaktstufe, die folgendes enthält:

"Push"-Transistor (T1) mit einem zwischen einer ersten Stromversorgungsleitung für eine hohe Versorgungsspannung (VDD) und einem Stufenausgang (K) angeordneten Stromkanal;

"Pull"-Transistor (T2) mit einem zwischen dem Ausgang (K) und einer zweiten Stromversorgungsleitung für eine niedrige Versorgungsspannung (VSS) angeordneten Stromkanal;

Steuermittel (CC) für die Versorgung einer Steuerelektrode des "Push"-Transistors (T1) und einer Steuerelektrode des "Pull"-Transistors (T2) mit zeitabhängigen Steuerspannungen, um die Logikzustände der Gegentaktstufe zu schalten und um das Spannungsrauschen auf den Versorgungsleitungen infolge von Stromschwankungen an dem Stufenausgang (K) zu reduzieren; dadurch gekennzeichnet, daß das Steuermittel (CC) während des Schaltens der Logikzustände einen ersten Strom (I1 bzw. I2) durch einen der genannten Transistoren (T1 bzw. T2) im wesentlichen konstant hält, bis ein größter Anstieg in einem zweiten Strom (I2 bzw. I1) durch den anderen der genannten Transistoren (T2 bzw. T1) aufgetreten ist, um nahzu sofort danach den ersten Strom (I1 bzw. I2) zu reduzieren.

2. Integrierte Logikschaltung nach Anspruch 1, wobei das Steuermittel (CC) einen zwischen der Steuerelektrode des "Pull"-Transistors (T2) und der zweiten Stromversorgungsleitung angeordneten Entladepfad (T8, T13, T14) und einen zwischen der Steuerelektrode des "Push"-Transistors (T1) und der ersten Stromversorgungsleitung angeordneten Ladepfad (T4, T5, T6) enthält, dadurch gekennzeichnet, daß der Entladepfad (T8, T13, T14) im leitenden Zustand einen kleineren Maximalstrom führt als der Ladepfad (T4, T5, T6) im leitenden Zustand.

3. Integrierte Logikschaltung nach Anspruch 2, dadurch gekennzeichnet, daß ein Verhältnis zwischen dem durch den Ladeplad (T4, T5, T6) geleiteten Maximalstrom und dem durch den Entladepfad (T8, T13, T14) geleiteten Maximalstrom in einem Bereich von 1,5 bis 10 liegt.

4. Integrierte Schaltung nach Anspruch 2 oder 3, dadurch gekennzeichnet, daß das Steuermittel (CC) einen weiteren Entladepfad zum Entladen der Steuerelektrode des "Push"-Transistors (T1) enthält, wobei der weitere Entladepfad einen Stromkanal eines Entlade-Transistors (T3) umfaßt, der die Steuerelektrode des "Push"-Transistors (T1) mit einem Knotenpunkt (K) zwischen dem Stromkanal des "Push"-Transistors (T1) und dem Stromkanal des "Pull"-Transistors (T2) verbindet.

5. Integrierte Logikschaltung nach Anspruch 4, dadurch gekennzeichnet, daß das Steuermittel (CC) eine Steuerschaltung (INV1) enthält, wobei in dem Ladepfad (T4, T5, T6) ein Stromkanal eines Schalttransistors (T4) mit der Steuerelektrode des "Push"-Transistors (T1) verbunden ist und der Schalttransistor (T4) zusammen mit dem Entlade-Transistor (T3) eine Inverterschaltung bildet.

6. Integrierte Logikschaltung nach Anspruch 5, wobei das Steuermittel (CC) eine zweite Steuerschaltung (INV2) enthält, die eine zweite Inverterschaltung (T8, T9) umfaßt, deren Ausgang mit der Steuerelektrode des "Pull"-Transistors (T2) verbunden ist und die durch einen zweiten Schalttransistor (T9) gebildet wird, wobei ein Stromkanal des zweiten Schalttransistors mit der Steuerelektrode des "Pull"-Transistors (T2) verbunden ist und in einem Ladepfad (T9, T10, T11) für die Steuerelektrode des "Pull"-Transistors (T2) angeordnet ist, und durch einen zweiten Entlade-Transistor (T8), von dem ein Stromkanal zwischen die Steuerelektrode des "Pull"-Transistors (T2) und die zweite Stromversorgungsleitung geschaltet ist; und wobei die Ladepfade (T4, T5, T6; T9, T10, T11) in der ersten bzw. der zweiten Steuerschaltung (INV1 und INV2) einen jeweiligen Kaskodentransistor (T5; T10) enthalten, dessen Stromkanal mit der ersten Stromversorgungsleitung verbunden ist und dessen Steuerelektrode mit einem Ausgang der jeweiligen Inverterschaltung (T3, T4; T8, T10) verbunden ist, und einen jeweiligen weiteren Kaskodentransistor (T6; T11) enthalten, dessen Stromkanal mit dem Stromkanal des jeweiligen Kaskodentransistors (T5; T10) parallelgeschaltet ist; dadurch gekennzeichnet, daß die Eingänge der ersten und der zweiten Inverterschaltung (T3, T4; T8, T9) über ein erstes bzw. ein zweites Verzögerungsglied (DL1; DL2) jeweils mit einer Steuerelektrode des jeweiligen weiteren Kaskodentransistors (T6; T11) verbunden sind.

7. Integrierte Logikschaltung nach Anspruch 2, 3, 4, 5 oder 6, dadurch gekennzeichnet, daß der Entladepfad (T8, T13, T14) zwischen der Steuerelektrode des "Pull"-Transistors (T2) und der zweiten Stromversorgungsleitung eine Parallelanordnung von mindestens einem ersten und einem zweiten Pfad enthält, wobei der erste Pfad (T8) in Abhängigkeit von einem dem Steuermittel (CC) zugeführten Steuersignal ausgeschaltet und der zweite Pfad (T13, T14) unter der Steuerung einer Spannung am Gatter-Ausgang eines Logik-Gatters (P1) ausgeschaltet wird, wobei ein erster Gatter-Eingang des Logik-Gatters (P1) mit der Steuerelektrode des "Pull"-Transistors (T2) und ein zweiter Gatter-Eingang mit dem Stufenausgang (K) verbunden ist.

8. Integrierte Logikschaltung nach Anspruch 7, dadurch gekennzeichnet, daß ein weiteres Verzögerungsglied (DL3) zwischen den Gatter-Ausgang und eine Steuerelektrode eines speziellen Transistors (T13) geschaltet ist, der einen in dem zweiten Pfad (T13, T14) angeordneten Stromkanal hat.

9. Integrierte Logikschaltung nach Anspruch 8, dadurch gekennzeichnet, daß die Steuerelektrode des speziellen Transistors (T13) über eine weitere Kapazität (T15) mit der zweiten Stromversorgungsleitung verbunden ist.

**Revendications**

1. Circuit logique intégré comportant un étage "push-pull" comprenant un transistor push (T1) présentant un canal de courant arrangé entre une première ligne d'alimentation électrique destinée à porter une tension d'alimentation élevée ($V_{DD}$) et une sortie (K) de l'étage, un transistor pull ($T_2$) présentant un canal de courant disposé entre la sortie (K) et une seconde ligne d'alimentation électrique destinée à porter une tension d'alimentation basse (VSS), des moyens de commande (CC) pour fournir à une électrode de commande du transistor push ($T_1$) et à une électrode de commande du transistor pull ($T_2$) des tensions de commande en fonction du temps afin de commuter des états logiques de l'étage push-pull et réduire le bruit de tension sur les lignes d'alimentation qui est dû à des variations de courant à la sortie (K) de l'étage, caractérisé en ce qu'au cours de la commutation des états logiques, les moyens de commande (CC) maintiennent un premier courant (I1 ou I2, respectivement) à travers un desdits transistors ($T_1$ ou $T_2$, respectivement) sensiblement constant jusqu'à ce qu'une augmentation maximale d'un second courant (I2 ou I1, respectivement) se soit produite à travers l'autre transistor ($T_2$ ou $T_1$, respectivement) pour réduire en substance immédiatement ensuite le premier courant (I1 ou I2, respectivement).

2. Circuit logique intégré selon la revendication 1, dans lequel les moyens de commande (CC) comprennent un trajet de décharge ($T_8$, $T_{13}$, $T_{14}$ arrangé entre l'électrode de commande du transistor pull ($T_2$) et la seconde ligne d'alimentation électrique et un trajet de charge ($T_4$, $T_5$, $T_6$) disposé entre l'électrode de commande du transistor push ($T_1$) et la première ligne d'alimentation électrique, caractérisé en ce que le trajet de décharge ($T_8$, $T_{13}$, $T_{14}$ conduit un courant maximum plus faible, lorsqu'il est conducteur, que le trajet de charge ($T_4$, $T_5$, $T_6$) lorsqu'il est conducteur.

3. Circuit logique intégré selon la revendication 2, caractérisé en ce qu'un rapport entre le courant maximum conduit par le trajet de charge ($T_4$, $T_5$, $T_6$) et le courant maximum conduit par le trajet de décharge ($T_8$, $T_{13}$, $T_{14}$) se situe dans une plage de 1,5 à 10.

4. Circuit logique intégré selon la revendication 2 ou 3, caractérisé en ce que les moyens de commande (CC) comprennent un autre trajet de décharge pour décharger l'électrode de commande du transistor push ($T_1$), ledit autre trajet de décharge comprenant un canal de courant d'un transistor de décharge ($T_3$) qui connecte l'électrode de commande du transistor push ($T_1$) à un noeud (K) entre le canal de courant du transistor push ($T_1$) et le canal de courant du transistor pull ($T_2$).

5. Circuit logique intégré selon la revendication 4, caractérisé en ce que les moyens de commande (CC) comprennent un circuit de commande (INV1) dans lequel, dans le trajet de charge ($\overline{T_4}$, $T_5$, $T_6$), un canal de courant d'un transistor de commutation ($T_4$) est connecté à l'électrode de commande du transistor pull ($T_1$), le transistor de commutation ($T_4$) formant un circuit inverseur conjointement avec le transistor de décharge ($T_3$).

6. Circuit logique intégré selon la revendication 5, dans lequel les moyens de commande (CC) comprennent un second circuit de commande (INV2) qui comprend un second circuit inverseur ($\overline{T_8}$, $T_9$) dont une sortie est connectée à l'électrode de commande du transistor pull ($T_2$) et qui est formé par un second transistor de commutation ($T_9$), avec un canal de courant connecté à l'électrode de commande du transistor pull ($T_2$) et disposé dans un trajet de charge ($T_9$, $T_{10}$, $T_{11}$) pour l'électrode de commande du transistor pull ($T_2$), et par un second transistor de décharge ($T_8$), avec un canal de courant connecté entre l'électrode de commande du transistor pull ($T_2$) et la seconde ligne d'alimentation électrique, et dans lequel les trajets de charge ($T_4$, $T_5$, $T_6$; $T_9$, $T_{10}$, $T_{11}$) de chacun des premier et second circuits de commande ($\overline{INV1}$ et $\overline{INV2}$) comprennent un transistor cascode respectif ($T_5$; $T_{10}$) ayant un canal de courant connecté à la première ligne d'alimentation électrique et une électrode de commande connectée à une sortie du circuit inverseur respectif ($T_3$, $T_4$; $T_8$, $T_9$), et comprennent un autre transistor cascode respectif ($T_6$; $T_{11}$) ayant un canal de courant connecté en parallèle avec le canal de courant du transistor cascode respectif ($T_5$; $T_{10}$), caractérisé en ce que des entrées du premier et du second circuit inverseur ($T_3$, $T_4$; $T_8$, $T_9$) sont connectées, respectivement, à une électrode de commande de l'autre transistor cascode respectif ($T_6$; $T_{11}$) via un premier et un second élément à temps (DL1; DL2), respectivement.

7. Circuit logique intégré selon la revendication 2, 3, 4, 5 ou 6, caractérisé en ce que le trajet de décharge ($T_8$, $T_{13}$, $T_{14}$) entre l'électrode de commande du transistor pull ($T_2$) et la seconde ligne d'alimentation électrique comprend un montage en parallèle d'au moins un premier et un second trajet, le premier trajet ($T_8$) étant mis hors circuit en fonction d'un signal de commande fourni par les moyens de commande (CC) et le second trajet ($T_{13}$, $T_{14}$) étant mis hors circuit sous la commande d'une tension à une sortie d'une porte logique (P1), la porte logique (P1) comportant une première entrée connectée à l'électrode de commande du transistor pull ($T_2$) et une seconde entrée connectée à la sortie (K) de l'étage.

8. Circuit logique intégré selon la revendication 7, caractérisé en ce qu'un autre élément à temps (DL3) est connecté entre la sortie de la porte et une électrode de commande d'un transistor spécifique ($T_{13}$) qui comporte un canal de courant disposé dans le second trajet ($T_{13}$, $T_{14}$).

9. Circuit logique intégré selon la revendication 8, caractérisé en ce que l'électrode de commande du transistor spécifique ($T_{13}$) est couplée à la seconde ligne d'alimentation électrique via une autre capacité ($T_{15}$).

FIG.1

FIG.2A

FIG.2B

EP 0 327 160 B1

FIG.3A

FIG.3B

FIG.5

10

FIG. 4